**Europäisches Patentamt**

(19) **European Patent Office**

**Office européen des brevets**

(11) Publication number: **0 166 706**
**B1**

(12) # EUROPEAN PATENT SPECIFICATION

(45) Date of publication of the patent specification:
**01.03.89**

(51) Int. Cl.⁴: **G 01 R 27/26**

(21) Application number: **85850189.3**

(22) Date of filing: **30.05.85**

(54) Method for the measurement of capacitances, in particular of low capacitances.

(30) Priority: **31.05.84 FI 842192**

(43) Date of publication of application:
**02.01.86 Bulletin 86/1**

(45) Publication of the grant of the patent:
**01.03.89 Bulletin 89/9**

(84) Designated Contracting States:
**CH DE FR GB IT LI NL SE**

(56) References cited:
**DE-A- 2 804 696**
**DE-A- 3 032 155**
**US-A- 4 295 090**
**US-A- 4 295 091**

(73) Proprietor: **VAISALA OY, Vanha Nurmijärventie 21,
SF-00420 Helsinki (FI)**

(72) Inventor: **Lyyra, Matti, Kaivosrinteentie 1-3 F 50,
SF-01610 Vantaa (FI)**

(74) Representative: **Rostovanyi, Peter et al, AWAPATENT
AB Box 5117, S-200 71 Malmö (SE)**

## Description

The present invention is concerned with a method for the measurement of capacitances, in particular of low capacitances, in which method a measurement oscillator is used, whose output frequency is a function of the capacitance to be connected to the input terminals of the circuit determining the frequency of the said oscillator and in which method a known reference capacitance is used, which is connected, being alternatingly exchanged with the capacitance to be measured, to the input terminals of the measurement oscillator while making use of a switching arrangement.

One starting point for the present invention has been the prior-art technology that comes out, e. g., from FI-A-54 664 and FI-A-57 319 (corresponding US-A-4 295 090 and US-A-4 295 091). In the said patents, a method is suggested for the measurement of low capacitances.

In radiosondes, for the measurement of various parameters, in particular of pressure, temperature and humidity, capacitive detectors are used, the magnitude of whose capacitance depends on the parameter being measured. The capacitances of these detectors are often relatively low, from a few pF to some dozens of pF, at the maximum about 100 pF. The measurement of low capacitances is problematic, e. g., owing to stray capacitances, variations in supply voltage, and other disturbances. Moreover, the said detectors are to some extent individual, so that they have an individual non-linearity and dependence on temperature.

In particular in telemeter applications, when, e. g., temperature, humidity or pressure is being measured by means of electric or mechano-electric detectors, it is common that, in connection with the measurement electronics, one or several references are provided which are precisely known, so that errors of the measurement circuit and/or of the detector can be eliminated.

In connection with capacitive detectors, it is known in prior art to use a reference capacitance, which is, alternatingly with the measuring capacitance, connected to the input of the measurement circuit, usually a circuit determining the frequency of a RC-oscillator. By appropriately adjusting the measurement circuit or in some other way, the corresponding output variable of the reference capacitance of the measurement circuit can be brought to the correct level.

It is known in prior art to use measurement circuits of one reference, in particular bridge connections, in which the measurement is, however, precise only when the electrical value of the reference is close to the value of the detector, e. g., when the bridge is in equilibrium. The more distant the value of the detector becomes from the reference, the larger will also the various errors be, e. g. errors caused by changes in the dynamics of the electronic measurement circuit. An advantage of connections with one reference is the simplicity of the measurement circuit.

An advantage in measurement arrangements with two or more references is accuracy of the measurement even within wide ranges of measurement, but a drawback is the complexity of the measurement method and of the related computation.

An objective of the present invention is a further development of the prior-art measurement circuits for low capacitances (0 to 100 pF) so that the measurement circuits become more precise. It is an additional objective of the invention to provide such a measurement circuit in which it is possible to eliminate the effects of switching phenomena.

A non-essential additional objective of the invention is to provide such a measurement circuit in which the output variable is an appropriately linearized, compensated and scaled DC voltage and to which, if required, a simple temperature compensation may be connected.

In view of achieving the above objectives and those that will come out in the following, the method in accordance with the invention is mainly characterized in that the capacitance to be measured and the reference capacitance are connected, alternatingly one after the other, to the input terminals of the same said measurement oscillator for the time of an equal number of cycles of the measurement oscillator.

The frequency of the oscillator is distributed preferably by means of an asynchronous or synchronous divider, and the square wave of the output of the divider is used for controlling analog switches, which exchange the capacitance to be measured with the reference capacitance.

In a preferred embodiment of the invention, the output of the divider also controls the data out buffers, one of whose operating voltage terminals has been brought out separately. Thereby, the amplitude of the square wave supplied by the data out buffers can be adjusted and used for linearization, compensation and scaling.

In the invention, by means of a parallel capacitance of the oscillator, a simple temperature compensation can be provided by choosing its temperature coefficient appropriately. The effects of the switching phenomena can be eliminated if the division ratio N of the said divider is sufficiently high, as a rule $N > 10$.

The temperature dependences of the oscillator affect the lengths of both of the half cycles in the same way, and compensate most of the temperature dependence of the electronics. The converting of the pulse ratio to DC voltage, the linearization, compensation and scaling can be accomplished relatively simply by means of data out buffers and RC low pass filter.

In the following, the invention will be described in detail with reference to certain exemplifying embodiments of the invention, illustrated in the figures of the attached drawing, the invention being by no means strictly confined to the details of the said embodiments.

Figure 1 shows the method in accordance with the invention as a wiring and block diagram.

Figure 2 shows the wave form of the voltage $V_{in}$, which contains the information to be measured.

Figure 3 shows, as a wiring diagram, linearization of the output voltage, advantageously applicable in connection with the method of the invention.

Figure 4 shows different wave forms in the wiring system shown in Fig. 3.

Figure 5 shows the output voltage of the pulse-ratio-DC-voltage transformer as a function of the capacitance to be measured.

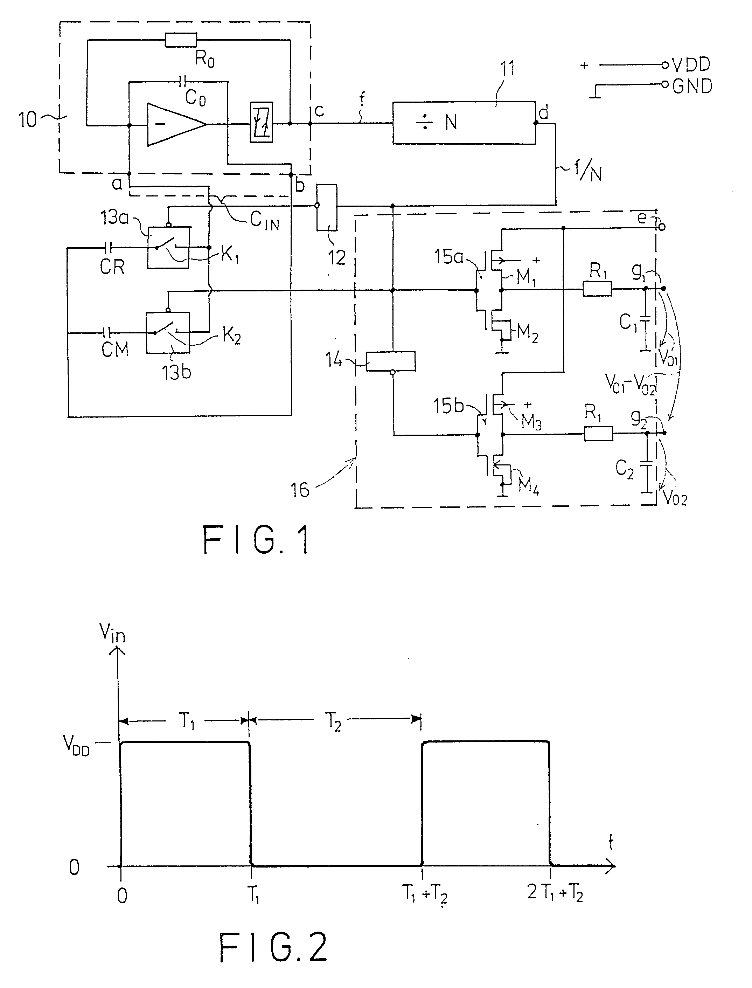

In accordance with Fig. 1, the method in accordance with the invention is carried into effect by making use of an oscillator 10, whereby the capacitance $C_M$ to be measured and a precisely known reference capacitance $C_R$ are alternatingly connected between the input terminals a and b of the circuit that determines the frequency of the said oscillator 10. Between the inlet terminals of the oscillator 10, a parallel capacitance $C_o$ is connected, with which the reference capacitance $C_R$ and $C_M$ are alternatingly connected in parallel. From the oscillator 10, a frequency f is obtained as an output variable, which said frequency f is a function of the capacitance $C_{in}$ connected to the inlet terminals:

$$f = F (C_{in}) \qquad (1)$$

$$f = \frac{A}{B(C_o + C_{in}) + \tau} \qquad (2)$$

wherein A and B are known constants, and
$\tau$ = a known time constant;
$c_{in} = C_R$ or $C_M$

The frequency obtained from the output terminal c of the oscillator 10 is passed to the divider 11, which is an asynchronous or synchronous divider, whose division ratio is N. From the divider 11 the output voltage $V_{in}$ is obtained, whose wave form comes out from Fig. 2.

It is an essential feature of the invention that the capacitance $C_M$ to be measured and the reference capacitance $C_R$ are alternatingly connected to the same oscillator 10 expressly for an equal number of cycles. This has been accomplished by dividing the frequency f of the oscillator 10 by the divider 11 mentioned above, whose division ratio is denoted with N, and by, by means of the square wave $V_{in}$ of the output of the divider 11, controlling the switches $k_1$ and $k_2$ via an inverter 12. The switches $k_1$ and $k_2$ are accomplished, e. g., as analog switches, which are illustrated by the blocks 13a and 13b. The switches $k_1$ and $k_2$ operate alternatingly so that when the switch $k_1$ is closed, the switch $k_2$ is open, and vice versa.

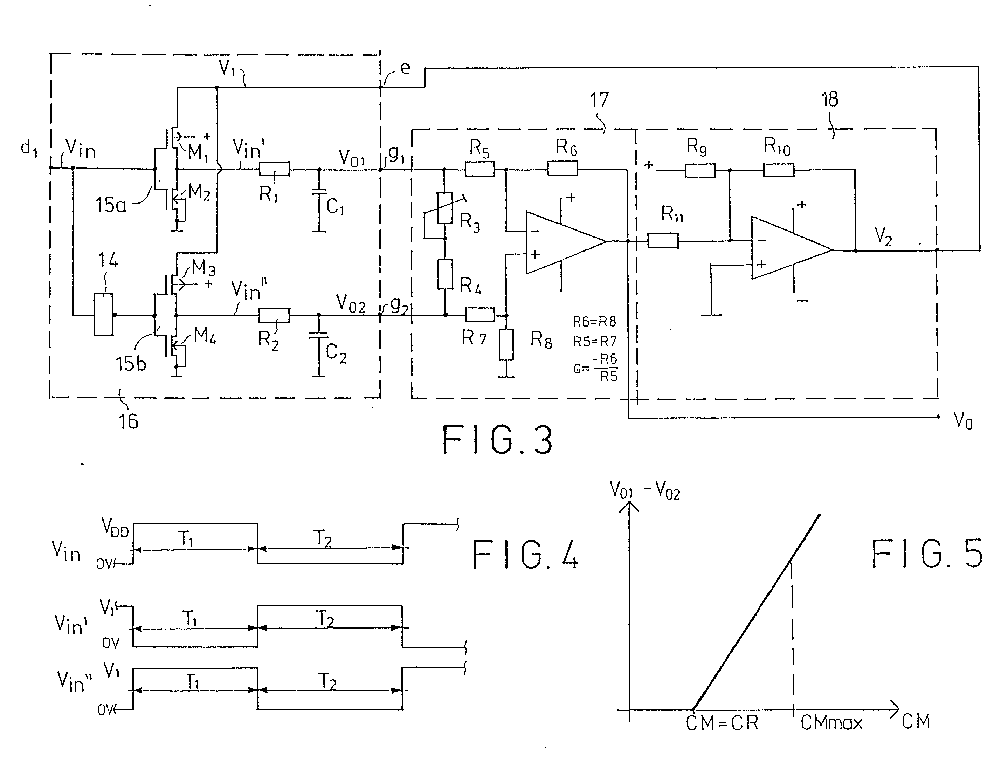

In accordance with Fig. 1, the output voltage $V_{in}$ of the divider 11 also controls the data out buffers 15a and 15b, one e ($V_1$) of whose operating voltage terminals has been brought out separately. Thereby, the amplitude of the square wave supplied by the data out buffers 15a and 15b can be adjusted and used for linearization, compensation and scaling, as will come out in more detail in the following in connection with the description of Figures 3, 4 and 5.

The information on the capacitance to be measured is contained in the half-cycle times $T_1$ and $T_2$ of the output voltage $V_{in}$ of the divider 11, in the way coming out from the following equations (3) to (6).

$$T_1 = \frac{N(B(C_o + C_M) + \tau)}{A} \qquad (3)$$

$$T_2 = \frac{N(B(C_o + C_R) + \tau)}{A} \qquad (4)$$

$$X_1 = \frac{T_1}{T_1 + T_2} \qquad (5)$$

$$X_2 = \frac{T_2}{T_1 + T_2} \qquad (6)$$

As was already stated above, the capacitance $C_M$ to be measured and the reference capacitance $C_R$ are alternatingly connected to the same oscillator circuit 10 for an equal number of cycles, the number of the said cycles being advantageously equal to the division ratio N of the divider 11. Thus, the switching times $T_1$ and $T_2$ are proportional to the number N of cycles and to the connected capacitance $C_{in}$. Under these circumstances, the half-cycle lengths $T_1$ and $T_2$ of the square wave $V_{in}$ of the output of the divider 11 are determined by the division ratio N and by the capacitances $C_M$ and $C_R$. The pulse ratios $X_1$ and $X_2$ obtained as output, which were defined above in the equations (5) and (6), are proportional to the magnitude of the capacitance $C_M$ to be measured, whereas the frequency f is inversely proportional to the said capacitance $C_M$.

According to a preferred embodiment of the invention, an output voltage illustrating the capacitance $C_M$ to be measured is obtained from the output terminals $g_1$ and/or $g_2$ of the data out buffer circuit or of the transformer 16, which said output voltage is linearized, temperature-compensated and scaled, making use of the following exemplifying solutions.

The said transformer 16 may be made of one part, in which case, out of the components 15a and 15b, it includes only the transistors $M_1/M_2$. Alternatively, the transformer 16 may be made of two parts, in which case, besides the said transistors $M_1/M_2$, it also includes an inverter 14 and transistors $M_3$ and $M_4$.

Output voltage with a one-part transformer:

$$V_{01} = X_1 \cdot V_1 \qquad (4a)$$

$$\text{wherein} \qquad X_1 = \frac{T_1}{T_1 + T_2} \qquad (5)$$

$$R_1 \cdot C_1 >> T_1 + T_2 \qquad (R_1 = R_2, \ C_1 = C_2) \qquad (5a)$$

Correspondingly, with a two-part transformer:

$$X_2 = \frac{T_2}{T_1 + T_2}, \quad \text{and } X_1 \text{ as above} \quad (6)$$

$$V_{01} - V_{02} = (X_1 - X_2) \cdot V_1 = \frac{T_1 - T_2}{T_1 + T_2} \cdot V_1 \quad (6a)$$

By varying the voltage $V_1$ to be supplied through the terminal e to the transformer 16, it is possible to adjust the amplitude of the square wave in accordance with the equation (6a) and, thereby, to provide an advantageous compensation, linearization and scaling of the output voltage.

The starting point of the compensation is that, in accordance with the above formulae (4a) and (6a), the output voltages either $V_{01}$ or $V_{01}-V_{02}$ can be compensated in respect of the desired parameter, e. g. the temperature, by arranging the voltage $V_1$ as a feedback voltage and the latter as in a suitable way dependent on the parameter to be compensated.

The main principle of linearization is that the output voltage is feedback-connected via the terminal e to the transformer 16 as a feedback voltage $V_1$. Thereby, the switch 15a/15b acts as a non-linear component, and as a result is obtained non-linear dependence of the output voltage on the pulse ratios $X_1$ and $X_2$ defined above (equations (5) and (6)).

The main principle of scaling is that, by adjusting the voltage $V_1$, in the method in accordance with the invention, the range of variation of the output voltage, constituting the output variable dependent on the capacitance $C_M$ to be measured (equations 4a and/or 6a), i. e. the scale, can be set at a suitable level.

In the following, with reference to Figures 3, 4 and 5, a more detailed exemplifying embodiment of the linearization, temperature compensation and scaling of the output voltage used in connection with the method in accordance with the invention will be described.

In accordance with Fig. 3, the input of an operation amplifier 17, whose amplification is denoted with G, is connected to the output terminals $g_1$ and $g_2$ of the transformer 16 described above. The output of the operation amplifier 17 is connected to the output of a resistively feedback-connected operation amplifier 18. From the operation amplifier 18, the output voltage $V_2$ is obtained.

The various wave forms $V_{in}$, $V_{in}'$ and $V_{in}''$ of the connections illustrated in Fig. 3 are shown in Fig. 4. With different parameters of the wiring system of Fig. 3, the following equations apply, the $X_1$ and $X_2$ present in them being defined in the above equations (5) and (6).

$$V_{01} - V_{02} = (X_1 - X_2) \cdot V_1 \quad (7)$$

$$V_0 = G \cdot (X_1 - X_2) \cdot V_1 \quad (8)$$

$$V_2 = G \cdot (X_1 - X_2) \cdot V_1 \cdot k_2 - k_1 \cdot V_{dd} \quad (9)$$

$$V_2 = V_1 \quad (10)$$

$$k_1 = \frac{R_{10}}{R_9} \quad (11)$$

$$k_2 = \frac{R_{10}}{R_{11}} \quad (12)$$

whereby, as fitted into equation (9),

$$V_1 (1 + G(X_1 - X_2) \cdot k_2) = - k_1 \cdot V_{dd} \quad (13)$$

$$V_1 = \frac{- k_1 \cdot V_{dd}}{1 + G(X_1 - X_2) \cdot k_2} \quad (14)$$

and, fitted into equation (8), we obtain

$$V_0 = - \frac{G \cdot k_1 \cdot V_{dd} (X_1 - X_2)}{1 + G \cdot (X_1 - X_2) \cdot k_2} \quad (15)$$

When the equation (15) is examined, it can be noticed that by changing the sign of the amplification G of the operation amplifier 17, the direction of the curvature of the characteristic curve of the circuit can be changed, and by means of the term $k_2$ (equation 12), the magnitude of the curvature can be adjusted.

In the following, with reference to Fig. 5, the use of a parallel capacitance $C_0$ for temperature compensation of the circuit will be described.

Frequency of a RC oscillator:

$$f_{osc} \sim \frac{A}{B(C_0 + C_k) +} \quad (16)$$

Temperature has a typical effect on the terms B and . B includes the temperature dependences of DC voltage and low frequency as well as the temperature dependences of the delay of.

On the basis of (1), (3) and (4), the lengths $T_1$ and $T_2$ of the half cycles of the pulse ratio output $V_{in}$ are:

$$T_1 = \frac{N(B(C_0 - C_M) + \tau)}{A} \quad (17)$$

$$T_2 = \frac{N(B(C_0 - C_R) + \tau)}{A} \quad (18)$$

In accordance with the above equation (7), the output of the pulse-ratio-DC-voltage transformer 16 is:

$$V_{01} - V_{02} \frac{T_1 - T_2}{T_1 + T_2} \cdot V_1 = \frac{C_M - C_R}{2C_0 + C_M + C_R + (2\tau/B)} \cdot V_1 \quad (19)$$

By appropriate choice of the temperature coefficient of $C_0$ (1), it is possible to compensate the temperature dependence of $2\tau/B$ partly.

With reference to Fig. 5, it is noticed that the temperature dependence of $2\tau/B$ attempts to alter the angle factor in Fig. 5 at high operating frequencies, whereby the share of $\tau$ in the time of the half-cycle is important. This can be compensated by means of $C_0$.

In the following, the patent claims will be given.

## Claims

1. Method for the measurement of capacitances, in particular of low capacitances, in which method a measurement oscillator (10) is used, whose output frequency (f) is a function ($f = F(C_{in})$) of the capacitance ($C_{in}$) to be connected to the input terminals (a, b) of the circuit determining the frequency of the said oscillator and in which method a known reference capacitance ($C_R$) is used, which is connected, being alternatingly exchanged with the capacitance ($C_M$) to be measured, to the input terminals (a, b) of the measurement oscillator (10) while making use of a switching arrangement, characterized in that the capacitance ($C_M$) to be measured and the reference capacitance ($C_R$) are connected, alternatingly one after the other, to the input terminals (a, b) of the same said measurement oscillator (10) for the time ($T_1$ and $T_2$) of an equal number (N) of cycles ($T = 1/f$) of the measurement oscillator (10).

2. Method as claimed in claim 1, characterized in that the frequency (f) dependent on the capacitances ($C_O$, $C_R$, $C_M$) connected to the input terminals (a, b) of the measurement oscillator (10) is passed to a divider (11), whose division ratio (N) directly determines the number (N) of the said switching cycles.

3. Method as claimed in claim 2, characterized in that the square wave ($V_{in}$) obtained from the output (d) of the said divider (11) is used for controlling the switches ($k_1$, $k_2$) which, while alternatingly exchanging them, connect the known reference capacitance ($C_R$) and the capacitance ($C_M$) to be measured, each in its turn, to the input terminals (a, b) of the measurement oscillator (10), so that an exchange of the level ($V_{dd}$, O) of the said square wave ($V_{in}$) produces an operation of the said switches ($k_1$, $k_2$) in such a way that the capacitance ($C_M$) that is the next one in the sequence and that is to be measured is connected in place of the reference capacitance ($C_R$), and vice versa.

4. Method as claimed in any of the claims 1 to 3, characterized in that the connection times ($T_1$ and $T_2$) of the various capacitances ($C_R$ and $C_M$) are proportional to the number (N) of the connection cycles and to the connected capacitance ($C_M$ or $C_R$).

5. Method as claimed in any of the claims 2 to 4, characterized in that, in order to eliminate the effect of switching phenomena, the said division ratio (N) has been chosen as N > 10.

6. Method as claimed in any of the claims 1 to 5, characterized in that in the method a transformer (16) is applied, as whose input signal the square wave ($V_{in}$) obtained from the said divider (11) is passed and from whose output terminals ($g_1$ and/or $g_2$) a DC voltage representing the capacitance to be measured is obtained, which said DC voltage is linearized, temperature-compensated and/or scaled.

7. Method as claimed in claim 6, characterized in that a feedback voltage ($V_1$) is fed through a certain terminal (e) of the said transformer (16), the amplitude of the said square wave ($V_1$) being adjusted, by varying the said feedback voltage, for the purpose of compensation, linearization and/or scaling of the output voltage of the transformer.

8. Method as claimed in claim 7, characterized in that, for the purpose of linearization of the output voltage of the said transformer (16), the said output voltage is passed as the said feedback voltage ($V_1$) to the non-linear component of the transformer so that a controlled non-linear dependence of the output voltage on the pulse ratios ($X_1$, $X_2$) of the said square wave (equations (5) and (6)) is produced.

9. Method as claimed in any of the claims 7 or 8, characterized in that in order to scale the output variable, the level of the said feedback voltage ($V_1$) is adjusted.

10 Method as claimed in any of the claims 6 to 8, characterized in that for the temperature compensation of the measurement circuit, a parallel capacitance ($C_o$) connected to the input terminals (a, b) of the measurement oscillator (10) is used, the temperature coefficient of the said parallel capacitance ($C_o$) being fitted so that the temperature dependences of the oscillator (10) are at least partly compensated (Fig. 5).

11. The use of a method as claimed in any of the claims 1 to 9 in radiosondes, in the telemeter measurement of pressure, temperature and/or humidity.

## Patentansprüche

1. Verfahren zur Messung von Kapazitäten, insbesondere niedriger Kapazitäten, unter Verwendung eines Meßoszillators (10), dessen Ausgangsfrequenz (f) eine Funktion ($f = F(C_{in})$) der Kapazität ($C_{in}$) ist, die an die Eingangsanschlüsse (a, b) des Schaltkreises angeschlossen werden soll, welcher die Frequenz des Oszillators bestimmt, und unter Verwendung einer bekannten Referenzkapazität ($C_R$), die an die Eingangsanschlüsse (a, b) des Meßoszillators (10) unter Verwendung einer Schaltanordnung angeschlossen und alternierend gegen die zu messende Kapazität ($C_M$) ausgetauscht wird, dadurch gekennzeichnet, daß die zu messende Kapazität ($C_M$) und die Referenzkapazität ($C_R$) alternierend nacheinander an die Eingangsanschlüsse (a, b) desselben Meßoszillators (10) für die Zeit ($T_1$ und $T_2$) einer gleichen Anzahl (N) von Zyklen ($T = 1/f$) des Meßoszillators (10) angeschlossen werden.

2. Verfahren nach Anspruch 1, dadurch gekennzeichnet, daß die von den an die Eingangsanschlüsse (a, b) des Meßoszillators (10) angeschlossenen Kapazitäten ($C_O$, $C_R$, $C_M$) abhängige Frequenz (f) an einen Teiler (11) geleitet wird, dessen Teilerverhältnis (N) direkt die Anzahl (N) der Schaltzyklen festlegt.

3. Verfahren nach Anspruch 2, dadurch gekennzeichnet, daß die Rechteckschwingung ($V_{in}$), die vom Ausgang (d) des Teilers (11) erhalten wird, zum Steuern der Schalter ($k_a$, $k_2$) verwendet wird, welche bei alternierendem Austausch die bekannte Referenzkapazität ($C_R$) und die zu messende Kapazität ($C_M$) jeweils an die Eingangsanschlüsse (a, b) des Meßoszillators (10) anschließen, so daß ein Wechsel des Pegels ($V_{dd}$, O) der Rechteckschwingung ($V_{in}$) eine Betätigung der Schalter ($k_1$, $k_2$) auf solche Weise erzeugt, daß die Kapazität ($C_M$), welche die nächste in der Abfolge ist und gemessen werden soll, an Stelle der Referenzkapazität ($C_R$) angeschlossen wird und umgekehrt.

4. Verfahren nach einem der Ansprüche 1 bis 3, dadurch gekennzeichnet, daß die Verbindungszeiten ($T_1$ und $T_2$) der verschiedenen Kapazitäten ($C_R$ und $C_M$) proportional zur Anzahl (N) der Verbindungszyklen und zur angeschlossenen Kapazität ($C_M$ oder $C_R$) sind.

5. Verfahren nach einem der Ansprüche 2 bis 4, dadurch gekennzeichnet, daß zur Beseitigung der Wirkung von Schaltphänomenen das Teilerverhältnis (N) zu N > 10 gewählt wurde.

6. Verfahren nach einem der Ansprüche 1 bis 5, dadurch gekennzeichnet, daß bei dem Verfahren ein Transformator (16) eingesetzt wird, als dessen Eingangssignal die Rechteckschwingung ($V_{in}$) übergeleitet wird, die von dem Teiler (11) erhalten wird, und von dessen Ausgangsanschlüssen ($g_1$ und/oder $g_2$) eine die zu messende Kapazität repräsentierende Gleichspannung erhalten wird, wobei die Gleichspannung linearisiert, temperaturkompensiert und/oder skaliert wird.

7. Verfahren nach Anspruch 6, dadurch gekennzeichnet, daß eine Rückkopplungsspannung ($V_1$) über einen bestimmten Anschluß (e) des Transformators (16) zugeführt wird, und daß die Amplitude der Rechteckschwingung ($V_1$) durch variieren der Rückkopplungsspannung zum Zwecke der Kompensation, Linearisation und/oder Skalierung der Ausgangsspannung des Transformators eingestellt wird.

8. Verfahren nach Anspruch 7, dadurch gekennzeichnet, daß zur Linearisierung der Ausgangsspannung des Transformators (16) die Ausgangsspannung als die Rückkopplungsspannung ($V_1$) dem nichtlinearen Bauteil des Transformators zugeleitet wird, so daß eine gesteuerte nichtlineare Abhängigkeit der Ausgangsspannung von den Impulsverhältnissen ($X_1$, $X_2$) der Rechteckschwingung (Gleichungen (5) und (6)) erzeugt wird.

9. Verfahren nach einem der Ansprüche 7 oder 8, dadurch gekennzeichnet, daß zur Skalierung der Ausgangsvariablen der Pegel der Rückkopplungsspannung ($V_1$) eingestellt wird.

10. Verfahren nach einem der Ansprüche 6 bis 8, dadurch gekennzeichnet, daß zur Temperaturkompensation der Meßschaltung eine an die Eingangsanschlüsse (a, b) des Meßoszillators (10) angeschlossene Parallelkapazität ($C_o$) verwendet wird, deren Temperaturkoeffizient so angepaßt ist, daß die Temperaturabhängigkeiten des Oszillators (10) zumindest teilweise kompensiert werden (Fig. 5).

11. Verwendung eines Verfahrens nach einem der Ansprüche 1 bis 9 in Radiosonden, bei der telemetrischen Messung von Druck, Temperatur und/oder Feuchte.

## Revendications

1. Procédé de mesure de capacités, en particulier de capacités faibles, dans lequel on utilise un oscillateur de mesure (10), dont la fréquence de sortie (f) est une fonction (f = F($C_{in}$)) de la capacité ($C_{in}$) qui est connectée aux bornes d'entrée (a, b) du circuit déterminant la fréquence de l'oscillateur, et dans lequel on utilise une capacité de référence connue ($C_R$), qui est connectée aux bornes d'entrée (a, b) de l'oscillateur de mesure (10), en étant échangée alternativement avec la capacité ($C_M$) à mesurer, par l'utilisation d'une configuration de commutation, caractérisé en ce que la capacité ($C_M$) à mesurer et la capacité de référence ($C_R$) sont connectées, en alternance et l'une après l'autre, aux bornes d'entrée (a, b) du même oscillateur de mesure (10), pendant la durée ($T_1$ et $T_2$) d'un nombre égal (n) de cycles (T = 1/f) de l'oscillateur de mesure (10).

2. Procédé selon la revendication 1, caractérisé en ce que la fréquence (f) qui dépend des capacités ($C_O$, $C_R$, $C_M$) connectées aux bornes d'entrée (a, b) de l'oscillateur de mesure (10), est transmise à un diviseur (11) dont le rang de division (N) détermine directement le nombre (N) des cycles de commutation.

3. Procédé selon la revendication 2, caractérisé en ce que l'onde carrée ($V_{in}$) qui est obtenue à la sortie (D) du diviseur (11) est utilisée pour commander les éléments de commutation ($k_1$, $k_2$) qui connectent la capacité de référence connue (C) et la capacité ($C_M$) à mesurer, chacune à son tour et en les échangeant alternativement, aux bornes d'entrée (a, b) de l'oscillateur de mesure (10), de façon qu'un changement du niveau ($V_{dd}$, O) de l'onde carrée ($V_{in}$) fasse fonctionner les éléments de commutation ($k_1$, $k_2$) d'une manière telle que la capacité ($C_M$) qui est la suivante en séquence, et qui doit être mesurée, soit connectée à la place de la capacité de référence ($C_R$), et inversement.

4. Procédé selon l'une quelconque des revendications 1 à 3, caractérisé en ce que les durées de connexion ($T_1$ et $T_2$) des diverses capacités ($C_R$ et $C_M$), sont proportionnelles au nombre (N) des cycles de connexion et à la capacité connectée ($C_M$ ou $C_R$).

5. Procédé selon l'une quelconque des revendications 2 à 4, caractérisé en ce que, dans le but d'éliminer l'effet de phénomènes de commutation, on a choisi le rang de division (N) de façon à avoir N > 10.

6. Procédé selon l'une quelconque des revendications 1 à 5, caractérisé en ce que dans le procédé, on utilise un circuit de transformation (16) qui reçoit en tant que signal d'entrée l'onde carrée ($V_{in}$) qui est fournie par le diviseur (11), et dont les bornes de sortie ($g_1$ et/ou $g_2$) fournissent une tension continue qui représente la capacité à mesurer, cette tension continue ayant fait l'objet d'une linéarisation, d'une compensation en température et/ou d'un réglage de la plage de variation.

7. Procédé selon la revendication 6, caractérisé en ce qu'une tension de réaction ($V_1$) est renvoyée

par une certaine borne (e) du circuit de transformation (16), et on règle l'amplitude de l'onde carrée ($V_1$) en faisant varier la tension de réaction, dans le but d'effectuer une compensation, une linéarisation et/ou un réglage de la plage de variation de la tension de sortie du circuit de transformation.

8. Procédé selon la revendication 7, caractérisé en ce que, dans le but de linéariser la tension de sortie du circuit de transformation (16), on transmet cette tension de sortie, sous la forme de la tension de réaction ($V_1$), au composant non linéaire du circuit de transformation, de façon à produire une dépendance non linéaire définie de la tension de sortie vis-à-vis des rapports d'impulsions ($X_1$, $X_2$) de l'onde carrée (équations (5) et (6)).

9. Procédé selon l'une quelconque des revendications 7 ou 8, caractérisé en ce qu'on règle le niveau de la tension de réaction ($V_1$), dans le but de régler la plage de variation de la variable de sortie.

10. Procédé selon l'une quelconque des revendications 6 à 8, caractérisé en ce que, dans le but d'effectuer la compensation en température du circuit de mesure, on utilise une capacité parallèle ($C_o$) qui est connectée aux bornes d'entrée (a, b) de l'oscillateur (10), et on choisit le coefficient de température de cette capacité parallèle ($C_o$) de façon à compenser au moins partiellement (figure 5) les dépendances de l'oscillateur (10), vis-à-vis de la température.

11. L'utilisation d'un procédé selon l'une quelconque des revendications 1 à 9 dans des radiosondes, dans la télémesure de la pression, de la température et/ou de l'humidité.

FIG. 1

FIG.2

FIG.3

FIG.4

FIG.5

$R6=R8$
$R5=R7$
$G=\dfrac{-R6}{R5}$